# EUROPEAN PATENT APPLICATION

(11) **EP 2 383 796 A1**
(43) Date of publication of application: **02.11.2011**
(21) Application number: 09834735.4
(22) Date of filing: 14.12.2009
(51) Int. Cl.: H01L 31/042

(54) **SOLAR CELL MODULE**

(30) Priority: 24.12.2008 JP 2008327954
(71) Applicant: Fuji Electric Co., Ltd., Kawasaki-shi, Kanagawa 210-9530 (JP)
(72) Inventor: WADA, Takehito, Kawasaki-shi Kanagawa 210-0856 (JP)
(74) Representative: MERH-IP Matias Erny Reichl Hoffmann
(86) International application number: PCT/JP2009/070832
(87) International publication number: WO 2010/073932

(57) **Abstract**

One embodiment of the invention provides a photovoltaic module capable of preventing a reduction in insulation resistance. The photovoltaic module includes a photoelectric conversion element (103) including a substrate (107) and a photoelectric conversion layer (109) that is formed on the substrate (109), a protective member (101) that is adhered to a light incident surface of the photoelectric conversion element (103) with a sealing member (105) interposed therebetween and protects a light incident surface of the photovoltaic module, a reinforcing member (102) that is adhered to a surface opposite to the light incident surface of the photovoltaic module with a sealing member (106) interposed therebetween and protects the photovoltaic module, and an insulating sheet (104) that is provided between the photoelectric conversion element (103) and the reinforcing member (102) to insulate the photoelectric conversion element (103).

## Description

### TECHNICAL FIELD

The present invention relates to a photovoltaic module with high insulation and weather resistance.

### BACKGROUND ART

In recent years, global warming has been caused by the greenhouse effect due to an increase in carbon dioxide and a photovoltaic device has drawn attention as a clean energy source that does not emit carbon dioxide. Examples of the photovoltaic device include a crystal type photovoltaic device, an amorphous photovoltaic device, and a compound semiconductor photovoltaic device, and various kinds of photovoltaic devices have been studied and developed. Among them, the amorphous silicon photovoltaic device has energy conversion efficiency lower than the crystal type photovoltaic device, but has the following advantages as compared to the other photovoltaic devices: it is easy to increase the area of the amorphous silicon photovoltaic device; the amorphous silicon photovoltaic device has a large light absorption coefficient; and the amorphous silicon photovoltaic device is formed of a thin film. Therefore, the amorphous silicon photovoltaic device has good prospects.

The amorphous silicon photovoltaic device has been widely used in the form of a photovoltaic module in which the photoelectric conversion element is sealed with a resin such that the photovoltaic module can be used outdoors for a long time. In the amorphous silicon photovoltaic module, it is possible to reduce the thickness of the substrate and reduce the weight of the photovoltaic module. Therefore, for example, when the photovoltaic module is installed on the roof of a building, it is possible to reduce a load applied to the building. In addition, it is possible to use a flexible substrate and make the photovoltaic module flexible. Therefore, the photovoltaic module has high designability.

In the amorphous silicon photovoltaic module, when the photoelectric conversion element is manufactured, stress is applied the substrate. Therefore, during sealing, the end of the substrate is warped and the substrate comes into contact with the protective member, which results in a reduction in insulation resistance. The photovoltaic module has a sufficient performance immediately after the photovoltaic module is manufactured. However, when the photovoltaic module is used outdoors for a long time, the end of the substrate is warped little by little and the insulation resistance is reduced. In order to solve this problem, a photovoltaic module has been proposed in which a glass nonwoven or a sheet member is provided on the entire surface of a photoelectric conversion element to prevent the deformation of a substrate, thereby preventing a reduction in insulation resistance (for example, see Patent Document 1).

### CITATION LIST

### PATENT DOCUMENT

Patent Document 1: Japanese Patent Application Laid-Open (JP-A) No. 10-27920

### DISCLOSURE OF INVENTION

### PROBLEMS TO BE SOLVED BY THE INVENTION

However, in the photovoltaic module, when the glass nonwoven is used, water is diffused through the interface of the sealing member or the glass nonwoven, which causes a reduction in insulation resistance. When the sheet member is used, the sheet member is wrinkled by thermal expansion and the effect of preventing a reduction in insulation resistance is reduced.

The invention has been made in view of the above-mentioned problems and an object of the invention is to provide a photovoltaic module capable of preventing a reduction in insulation resistance.

### MEANS FOR SOLVING THE PROBLEMS

According to an aspect of the invention, a photovoltaic module includes a photoelectric conversion element including a flexible substrate and a photoelectric conversion layer that is formed on the flexible substrate, protective members that are provided on both surfaces of the photoelectric conversion element and are adhered to the photoelectric conversion element with sealing members interposed therebetween, and a sheet that is provided between the photoelectric conversion element and at least one of the protective members and has rigidity and insulation higher than those of the sealing member under manufacturing conditions of the photovoltaic module and installed conditions for use of the photovoltaic module.

According to this structure, it is possible to insulate the photoelectric conversion element with the insulating sheet provided between the photoelectric conversion element and the protective member. Therefore, even when the photoelectric conversion element is warped, it is possible to prevent a reduction in insulation resistance. Therefore, it is possible to achieve a photovoltaic module that can be used for a long time under the manufacturing conditions of the photovoltaic module and the installed conditions for the use of the photovoltaic module.

In the photovoltaic module according to the above-mentioned aspect of the invention, the sheet may be arranged on the side to which at least four corners of the photoelectric conversion element are warped at positions including the four corners.

According to this structure, the insulating sheet is arranged at the four corners of the photoelectric conversion element where the photoelectric conversion element is largely warped. Therefore, it is possible to prevent a reduction in the insulation performance of the photovoltaic module without arranging the sheet on the entire surface of the photoelectric conversion element and thus reduce the area of the insulating sheet to be arranged.

In the photovoltaic module according to the above-mentioned aspect of the invention, the sheet may be arranged on the side to which the four corners of the photoelectric conversion element are warped at positions including each side of both ends of the photoelectric conversion element in the longitudinal direction.

According to this structure, the insulating sheet is arranged so as to include each side of both ends of the photoelectric conversion element in the longitudinal direction where the photoelectric conversion element is largely warped. Therefore, it is possible to prevent a reduction in the insulation resistance of the photovoltaic module without arranging the sheet on the entire surface of the photoelectric conversion element and thus reduce the area of the insulating sheet to be arranged.

In the photovoltaic module according to the above-mentioned aspect of the invention, the sheet may be arranged on the side to which the four corners of the photoelectric conversion element are warped at the positions including each side of both ends of the photoelectric conversion element in the longitudinal direction and may be arranged between the protective member and the sealing member.

According to this structure, the insulating sheet is arranged so as to include each side of both ends of the photoelectric conversion element in the longitudinal direction where the photoelectric conversion element is largely warped. Therefore, it is possible to prevent a reduction in the insulation resistance of the photovoltaic module without arranging the sheet on the entire surface of the photoelectric conversion element and thus reduce the area of the insulating sheet to be arranged.

In the photovoltaic module according to the above-mentioned aspect of the invention, the sheet may have optical transparency and may be provided on a light incident surface of the photoelectric conversion element.

According to the above-mentioned structure, the insulating sheet having optical transparency is arranged on the light incident surface. Therefore, even when the photoelectric conversion element is warped to the light incident surface, it is possible to prevent a reduction in insulation resistance.

In the photovoltaic module according to the above-mentioned aspect of the invention, the sheet may be provided on a protruding portion of the photoelectric conversion element when the photoelectric conversion element is warped.

According to the above-mentioned structure, the insulating sheet is provided on the protruding portion of the photoelectric conversion element when the photoelectric conversion element is warped. Therefore, it is possible to effectively prevent a reduction in the insulation resistance of the photoelectric conversion element.

### Advantages of the Invention

According to the invention, it is possible to provide a photovoltaic module that can be formed at a low cost and can prevent a reduction in insulation resistance.

### Brief Description of Drawings

Fig. 1 is a diagram illustrating the laminated structure of a photovoltaic module according to an embodiment of the invention.
Fig. 2 is a plan view illustrating the arrangement of insulating sheets in the photovoltaic module according to the embodiment of the invention.
Fig. 3 is a conceptual diagram illustrating the deformed state of a photoelectric conversion element of the photovoltaic module according to the embodiment of the invention.
Figs. 4(a) and 4(b) are cross-sectional views illustrating the laminated structure of the photovoltaic module according to the embodiment of the invention after a laminate process.
Fig. 5(a) is a diagram schematically illustrating an example in which the insulating sheets are provided on the upper and lower surfaces of the photoelectric conversion element in the photovoltaic module according to this embodiment and Fig. 5(b) is a plan view schematically illustrating an example of the deformation of the photoelectric conversion element and the arrangement of the insulating sheets.
Figs. 6(a) to 6(c) are diagrams illustrating an example of the arrangement of the insulating sheets on the lower surface of the photoelectric conversion element in the photovoltaic module according to the embodiment of the invention.
Figs. 7(a) to 7(c) are diagrams illustrating an example of the arrangement of the insulating sheets on the upper surface of the photoelectric conversion element in the photovoltaic module according to the embodiment of the invention.
Figs. 8(a) to 8(f) are diagrams schematically illustrating an example of the laminated structure of the photovoltaic module according to the embodiment of the invention.
Figs. 9(a) to 9(f) are cross-sectional views illustrating an example of the laminated structure of the photovoltaic module according to the embodiment of the invention after the laminate process.
Figs. 10(a) to 10(f) are diagrams schematically illustrating another example of the laminated structure of the photovoltaic module according to the embodiment of the invention.
Figs. 11(a) to 11(f) are cross-sectional views illustrating another example of the laminated structure of the photovoltaic module according to the embodiment of the invention after the laminate process.

### Best Mode for Carrying Out the Invention

Hereinafter, exemplary embodiments of the invention will be described in detail with reference to the accompanying drawings.

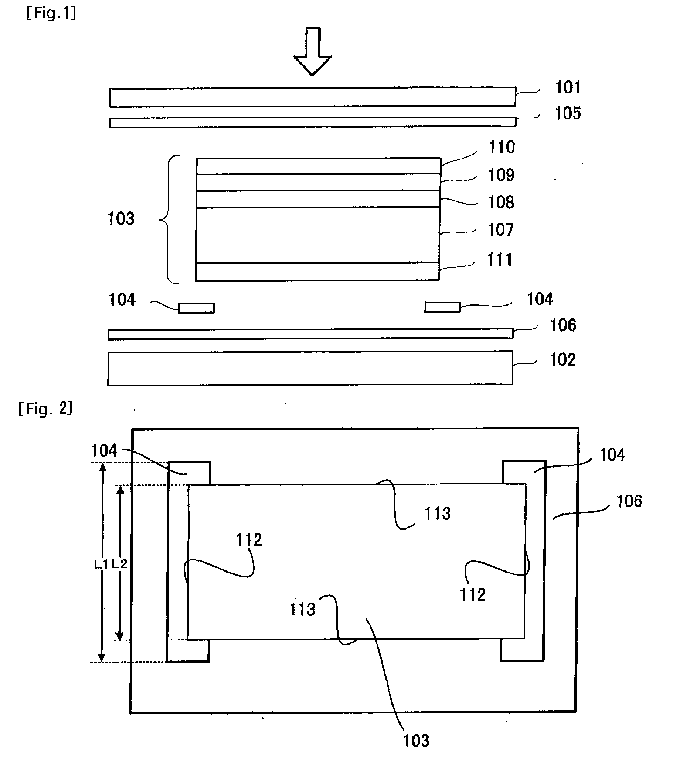

Fig. 1 is a diagram illustrating an example of the laminated structure of a photovoltaic module according to an embodiment of the invention. As shown in Fig. 1, the photovoltaic module according to this embodiment includes a protective member 101 that protects a light incident surface (hereinafter, referred to as the upper surface) of the photovoltaic module represented by an arrow in Fig. 1, a reinforcing member 102 that protects a surface (hereinafter, referred to as the lower surface) opposite to the light incident surface of the photovoltaic module, and a photoelectric conversion element 103 that is provided between the protective member 101 and the reinforcing member 102 and converts sunlight into a current. Two insulating sheets 104 are provided at both ends of the photoelectric conversion element 103 between the photoelectric conversion element 103 and the reinforcing member 102 and insulate the photoelectric conversion element 103 from the reinforcing member 102. A sealing member 105 is provided between the photoelectric conversion element 103 and the protective member 101 and a sealing member 106 is provided between the insulating sheets 104 and the reinforcing member 102. The protective member 101 and the reinforcing member 102 may be made of any material capable of protecting the photovoltaic module. The protective member 101 and the reinforcing member 102 may be made of the same material or different materials.

An electrode 108 that extracts a positive (or negative) charge subjected to photoelectric conversion, a photoelectric conversion layer 109 that converts sunlight into an electric signal, and a transparent electrode 110 that extracts a negative (or positive) charge subjected to photoelectric conversion are sequentially laminated on the upper surface of a substrate 107 of the photoelectric conversion element 103 from the upper surface of the substrate 107. A connection electrode 111 that connects the electrode 108 and the transparent electrode 110 is formed on the lower surface of the substrate 107.

Next, the arrangement of the insulating sheets 104 will be described with reference to Fig. 2.
Fig. 2 is a plan view illustrating the arrangement of the insulating sheets 104 in the photovoltaic module according to the embodiment of the invention. However, for convenience of explanation, the protective member 101, the sealing member 105, and the reinforcing member 102 are not shown in Fig. 2. As shown in Fig. 2, in the photovoltaic module according to this embodiment, the sealing member 106 has a rectangular shape in a plan view and the rectangular photoelectric conversion element 103 is laminated inside the sealing member 106 in a plan view. The photoelectric conversion element 103 is arranged such that the longitudinal direction of the sealing member 106 is substantially parallel to the longitudinal direction of the photoelectric conversion element 103. The two insulating sheets 104 having a rectangular shape in a plan view are provided at both ends of the photoelectric conversion element 103 in the longitudinal direction so as to cover the short sides of the photoelectric conversion element 103.

The insulating sheet 104 is formed in a substantially rectangular shape such that the length L1 of the insulating sheet 104 in the longitudinal direction is more than the length L2 of one side of a longitudinal end 112 of the photoelectric conversion element 103. The insulating sheets 104 are arranged at both ends of the photoelectric conversion element 103 in the longitudinal direction such that the center of the insulating sheet 104 in the lateral direction substantially overlaps the longitudinal end 112 of the photoelectric conversion element 103 and are laminated between the photoelectric conversion element 103 and the sealing member 106. One side of the longitudinal end 112 of the photoelectric conversion element 103 is laminated so as to be covered by the insulating sheet 104. However, the structure of the photovoltaic module shown in Figs. 1 and 2 is an example of the arrangement of the insulating sheets 104, and the arrangement position of the insulating sheet 104 is not limited to the longitudinal end 112 of the photoelectric conversion element 103. For example, the insulating sheet 104 may be provided at a lateral end 113, which will be described below.

In this embodiment, the photovoltaic module having each component laminated therein is formed by a laminate process. In the laminate process, the sealing member 106 and the reinforcing member 102 (lower protective member) are arranged on the lower surface, which is a surface opposite to the light incident surface, of the photoelectric conversion element 103, and the sealing member 105 and the upper surface protective member 101 are arranged on the upper surface which is the light incident surface. For example, the insulating sheets 104, a sealing member, an adhesive member, and a transparent insulating sheet are provided according to the conditions of use of the photovoltaic module. The laminate process is performed by heating and vacuum laminate, with each component arranged in this way.

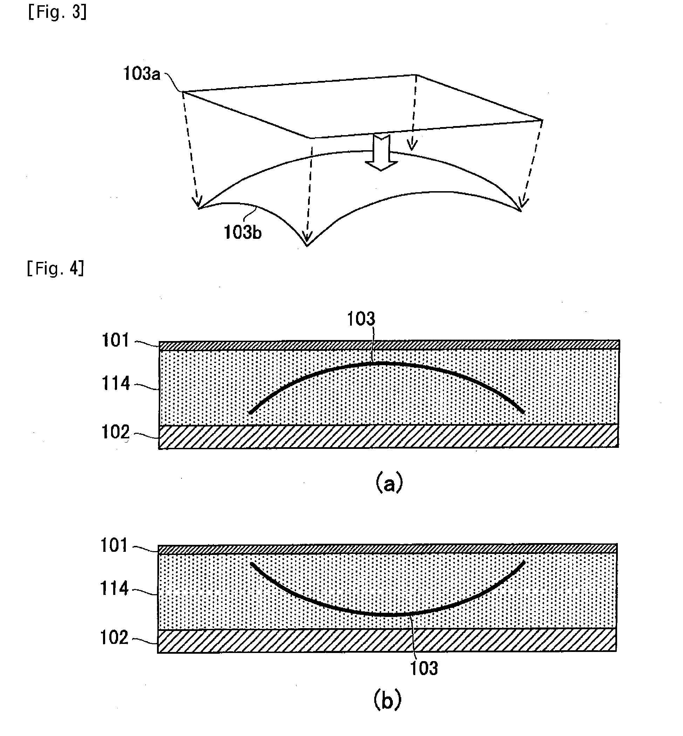

In the laminate process of the photovoltaic module, warping occurs in the photoelectric conversion element 103 due to the residual stress of the substrate 107 in a process of manufacturing the photoelectric conversion element 103. The deformed state of the photoelectric conversion element 103 in the laminate process will be described with reference to Fig. 3 and Figs. 4(a) and 4(b). However, Fig. 3 and Figs. 4(a) and 4(b) show the photovoltaic module when the insulating sheet 104 is not provided in the laminated structure shown in Fig. 1.

Fig. 3 is a conceptual diagram illustrating the deformed state of the photoelectric conversion element 103. As shown in Fig. 3, a photoelectric conversion element 103b has a plate shape before the laminate process and the photoelectric conversion element 103a is deformed in a dome shape in which four corners are warped downward and a central portion protrudes upward in the laminate process. As such, in the laminate process, since the four corners of the photoelectric conversion element 103 are warped downward, the photoelectric conversion element 103 contacts or approaches the protective member 101 or the reinforcing member 102.

Figs. 4(a) and 4(b) are cross-sectional views illustrating the laminated structure of the photovoltaic module after the laminate process. As shown in Fig. 4(a), in this embodiment, in the laminate process, the gap between the protective member 101 and the reinforcing member 102 is sealed as the insulating layer 114 by the sealing members 105 and 106.
In the laminate process, both ends of the photoelectric conversion element 103 which are warped to the lower surface approach the upper surface of the reinforcing member 102. Therefore, it is possible to prevent a reduction in the insulation resistance between both ends of the photoelectric conversion element 103 and the reinforcing member 102.

In the above-mentioned example, the four corners of the photoelectric conversion element 103 are warped to the lower surface and the central portion thereof protrudes toward the upper surface. However, the direction in which the photoelectric conversion element 103 is deformed varies depending on the warped state of the substrate 107 or residual stress during the manufacture of the substrate 107. Fig. 4(b) is a diagram illustrating the laminated structure when the four corners of the photoelectric conversion element 103 are warped to the upper surface and the central portion thereof protrudes toward the lower surface. As shown in Fig. 4(b), in this example, the central portion of the photoelectric conversion element 103 protrudes downward to approach the reinforcing member 102 and both ends of the photoelectric conversion element 103 approach the upper protective member 101. Therefore, in this example, it is necessary to prevent a reduction in the insulation resistance between the protective member 101 and the photoelectric conversion element 103 and a reduction in the insulation resistance between the central portion of the photoelectric conversion element 103 and the reinforcing member 102.

The photovoltaic module according to this embodiment is installed on, for example, the roof of the house and is used in the temperature range from room temperature to about 80°C under the actual conditions of use. Under these conditions of use, a portion of the sealing members 105 and 106 (insulating layer 114) is softened and the photoelectric conversion element 103 is likely to be deformed. Therefore, the photoelectric conversion element 103 having a plate shape immediately after manufacture is gradually deformed under the actual conditions of use of the photovoltaic module. As in the example shown in Fig. 3, the photoelectric conversion element 103 is not necessarily uniformly deformed, and the deformation of the photoelectric conversion element 103 varies depending on, for example, the distribution of the residual stress of the substrate 107 of the photoelectric conversion element 103 or the shape of the substrate 107. Therefore, in this embodiment, the insulating sheets are arranged on the upper surface, which is the light incident surface of the photoelectric conversion element 103, and the lower surface, which is a surface opposite to the light incident surface, at the position where the amount of protrusion of the photoelectric conversion element 103 is large, if needed, thereby preventing a reduction in the insulation resistance of the photovoltaic module. Next, an example of the arrangement of the insulating sheets of the photovoltaic module will be described.

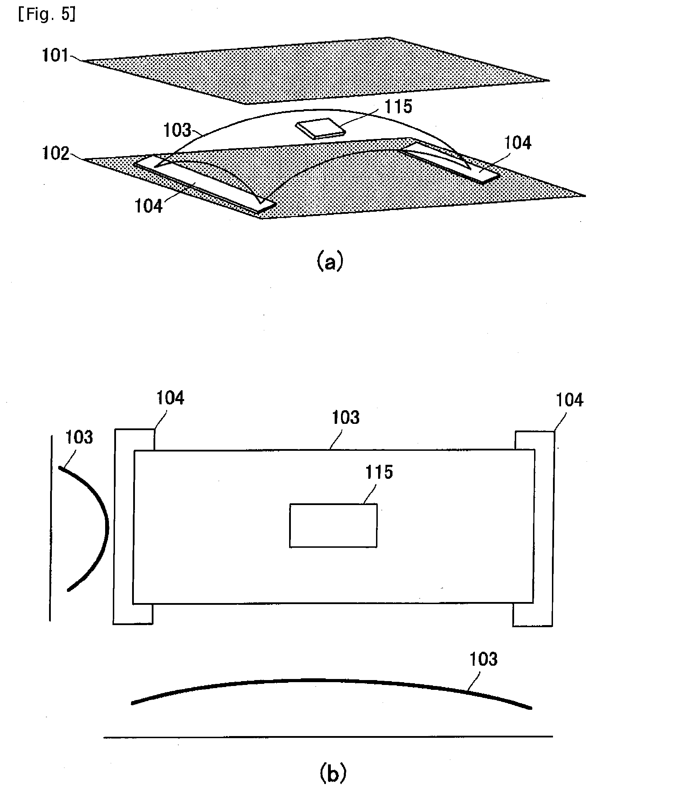

An example of the arrangement of the insulating sheets in which the insulating sheets 104 and 115 are provided on the upper surface and the lower surface of the photoelectric conversion element 103 will be described with reference to Figs. 5(a) and 5(b). Fig. 5(a) is a diagram schematically illustrating an example in which the insulating sheets 104 and 115 are provided on the upper surface and the lower surface of the photoelectric conversion element 103 in the photovoltaic module according to this embodiment. As shown in Fig. 5(a), when four corners of the photoelectric conversion element 103 are warped downward and the central portion thereof protrudes upward, the insulating sheets 104 are arranged on the lower surface of the photoelectric conversion element 103 so as to cover both ends of the photoelectric conversion element 103 in the longitudinal direction, and the insulating sheet 115 is arranged on the upper surface of the photoelectric conversion element 103 at the center of the photoelectric conversion element 103. When the insulating sheets 104 and 115 are arranged in this way, it is possible to prevent a reduction in the insulation resistance between the photoelectric conversion element 103, and the protective member 101 and the reinforcing member 102.

Fig. 5(b) is a plan view schematically illustrating an example of the deformation of the photoelectric conversion element 103 and the arrangement of the insulating sheets 104 and 115. Fig. 5(b) shows only the photoelectric conversion element 103, the insulating sheet 115 provided on the upper surface of the photoelectric conversion element 103, and the insulating sheets 104 provided on the lower surface of the photoelectric conversion element 103, and does not show the other members. In Fig. 5(b), the vertical axis indicates the deformed state of the photoelectric conversion element 103 in the short-side direction and the vertical axis indicates the deformed state of the photoelectric conversion element 103 in the long-side direction. As shown in Fig. 5(b), when the photoelectric conversion element 103 has a dome shape in which the central portion protrudes upward, the central portion of the photoelectric conversion element 103 protrudes toward the uppermost side. Therefore, when the insulating sheet 104 is provided at the center of the upper surface of the photoelectric conversion element 103, it is possible to prevent a reduction in the insulation resistance between the protective member 101 and the photoelectric conversion element 103. However, the insulating sheet 115 provided on the light incident surface of the photoelectric conversion element 103 transmits at least light with a wavelength required to generate power from the photovoltaic device. The insulating sheet 115 may be made of any material capable of transmitting light. The insulating sheet 115 may be made of a colored material or a colorless material.

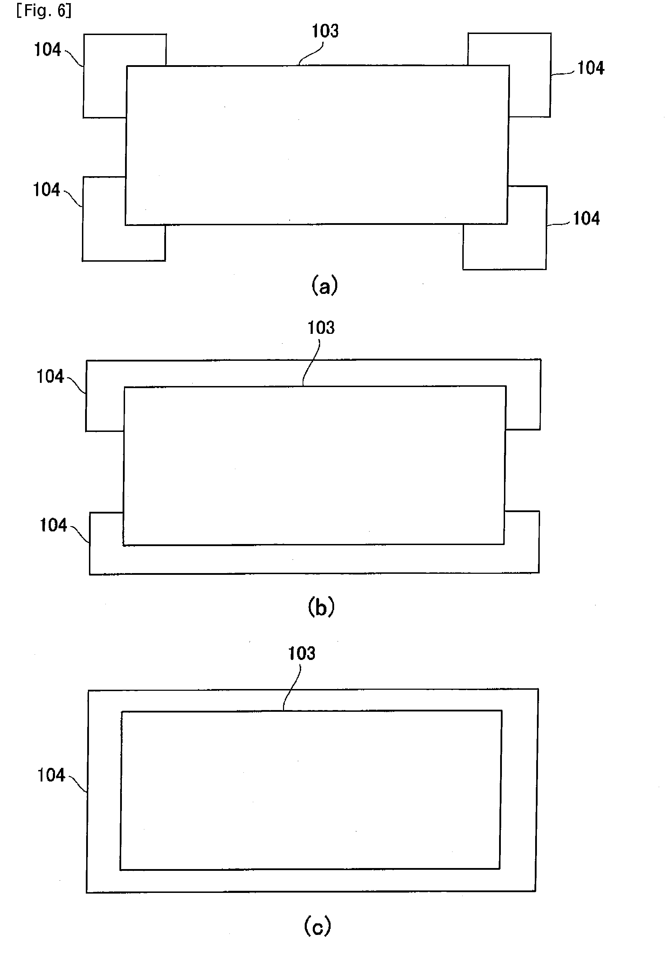

Next, an example of the arrangement of the insulating sheets 104 on the lower surface of the photoelectric conversion element 103 will be described with reference to Figs. 6(a) to 6(c). In this embodiment, in addition to the arrangement of the insulating sheets 104 shown in Fig. 2, the insulating sheets 104 are arranged according to the warping of the photoelectric conversion element 103. Fig. 6(a) shows an example in which four rectangular insulating sheets 104 are arranged so as to cover four corners of the lower surface of the photoelectric conversion element 103. As shown in Fig. 5(a), when four corners of the photoelectric conversion element 103 are warped downward and the central portion thereof protrudes toward the upper surface, four corners of the lower surface protrude toward the lowermost side. Therefore, as shown in Fig. 6(a), when the insulating sheets 104 are arranged so as to cover at least four corners of the photoelectric conversion element 103, it is possible to prevent a reduction in insulation resistance. Fig. 6(b) shows an example in which two rectangular insulating sheets 104 are arranged so as to cover both ends of the photoelectric conversion element 103 in the lateral direction. When the amount of protrusion of the photoelectric conversion element 103 to the long side is more than that the amount of protrusion of the photoelectric conversion element 103 to the short side, this arrangement makes it possible to effectively prevent a reduction in insulation resistance. Fig. 6(c) shows an example in which one insulating sheet 104 is arranged so as to cover the entire lower surface of the photoelectric conversion element 103. When the substrate 107 of the photoelectric conversion element 103 is deformed in a wave shape, the structure in which the insulating sheets 104 and 115 are arranged so as to cover the entire surface of the photoelectric conversion element 103 makes it possible to effectively prevent a reduction in insulation resistance. As such, in this embodiment, the insulating sheets 104 and 115 are arranged at positions including at least four corners in the direction in which four corners of the photoelectric conversion element 103 are warped.

However, the width of the insulating sheet 104 provided at the end of the photoelectric conversion element 103 is not particularly limited as long as a reduction in the insulation resistance of the photoelectric conversion element 103 can be prevented. For example, as shown in Fig. 2, when the insulating sheets 104 are arranged so as to cover both ends of the photoelectric conversion element 103 in the longitudinal direction and the length of the long side of the substrate 107 is about 1 m, the width of the insulating sheet 104 may be about 2 cm. In this case, as shown in Fig. 6(c), when the insulating sheet 104 is arranged so as to cover the entire lower surface of the photoelectric conversion element 103, the insulating sheet 104 having a long side with a length of more than 1 m is needed. However, in the structure shown in Fig. 2, since the sum of the widths of the two insulating sheets 104 is about 4 cm, it is possible to prevent a reduction in insulation resistance using the insulating sheets 104 with an area that is equal to or less than 1/25 of the area of the insulating sheet 104 covering the entire lower surface of the photoelectric conversion element 103. As such, in this embodiment, since the insulating sheet 104 is arranged in at least a portion of the photoelectric conversion element 103 in which the amount of protrusion of the photoelectric conversion element 103 is large, it is possible to prevent a reduction in insulation resistance.

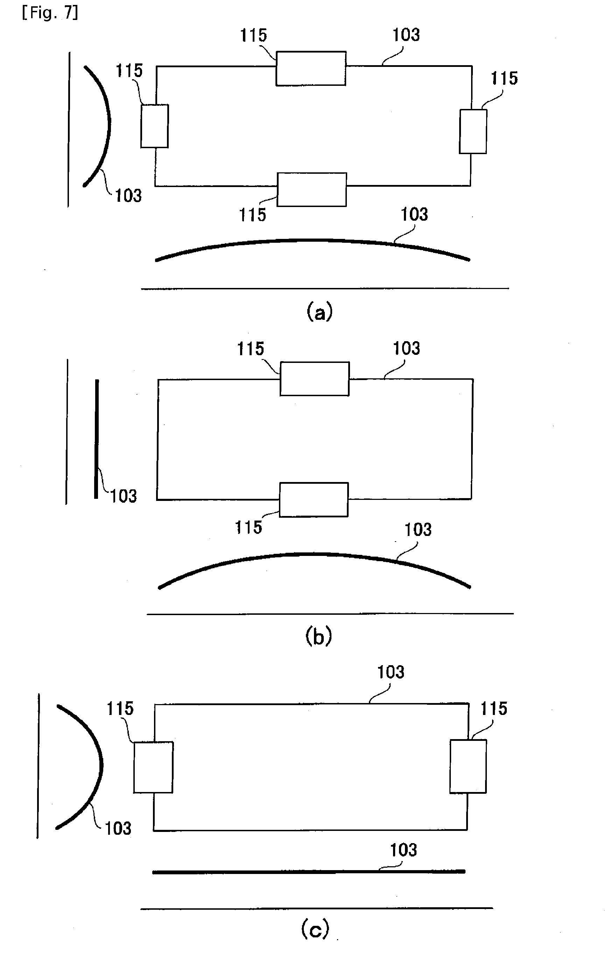

Next, an example of the arrangement of the insulating sheets 115 on the upper surface of the photoelectric conversion element 103 in the photovoltaic module according to this embodiment will be described in detail with reference to Figs. 7(a) to 7(c). Fig. 7(a) shows an example of the insulating sheets 115 when the amount of protrusion of the photoelectric conversion element 103 is substantially uniform in the short-side direction and the long-side direction of the photoelectric conversion element 103. In this case, the insulating sheets 115 having a rectangular shape in a plan view are arranged at the centers of four sides of the photoelectric conversion element 103. This arrangement makes it possible to prevent a reduction in the insulation resistance between the photoelectric conversion element 103 and the protective member 101.

Fig. 7(b) shows an example of the arrangement of the insulating sheets 115 when the amount of protrusion of the photoelectric conversion element 103 is particularly large in the long-side direction. In this case, the insulating sheets 115 are arranged at the centers of the long sides of the photoelectric conversion element 103 where the amount of protrusion is large. This arrangement makes it possible to prevent a reduction in the insulation resistance between the photoelectric conversion element 103 and the protective member 101.

Fig. 7(c) shows an example of the arrangement of the insulating sheets 115 when the amount of protrusion of the photoelectric conversion element 103 is particularly large in the short-side direction. In this case, the insulating sheets 115 are arranged at the centers of the short sides of the photoelectric conversion element 103 where the amount of protrusion is large. This arrangement makes it possible to prevent a reduction in the insulation resistance between the photoelectric conversion element 103 and the protective member 101.

As such, the insulating sheets 115 on the upper surface of the photoelectric conversion element 103 can be arranged at any positions on the upper surface and/or the lower surface of the photoelectric conversion element 103 according to the amount of protrusion of the photoelectric conversion element 103. In the above-mentioned example, the photoelectric conversion element 103 protrudes toward the upper surface. However, the photoelectric conversion element 103 protrudes toward the upper surface or the lower surface by the residual stress of the substrate 107. Therefore, when the insulating sheets 115 are arranged at any positions on the upper surface or the lower surface of the photoelectric conversion element 103, it is possible to prevent a reduction in the insulation resistance of the photoelectric conversion element 103.

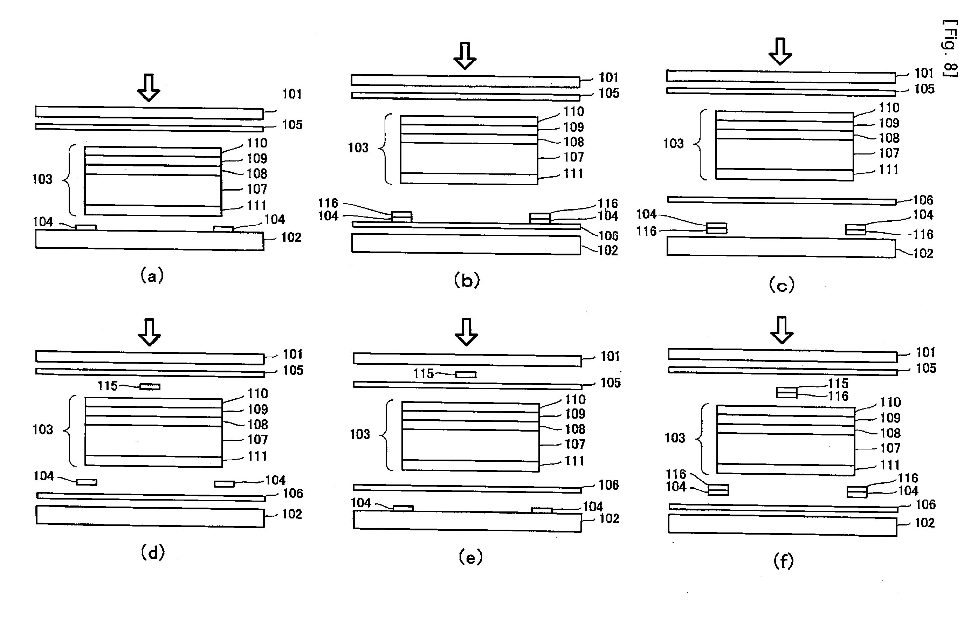

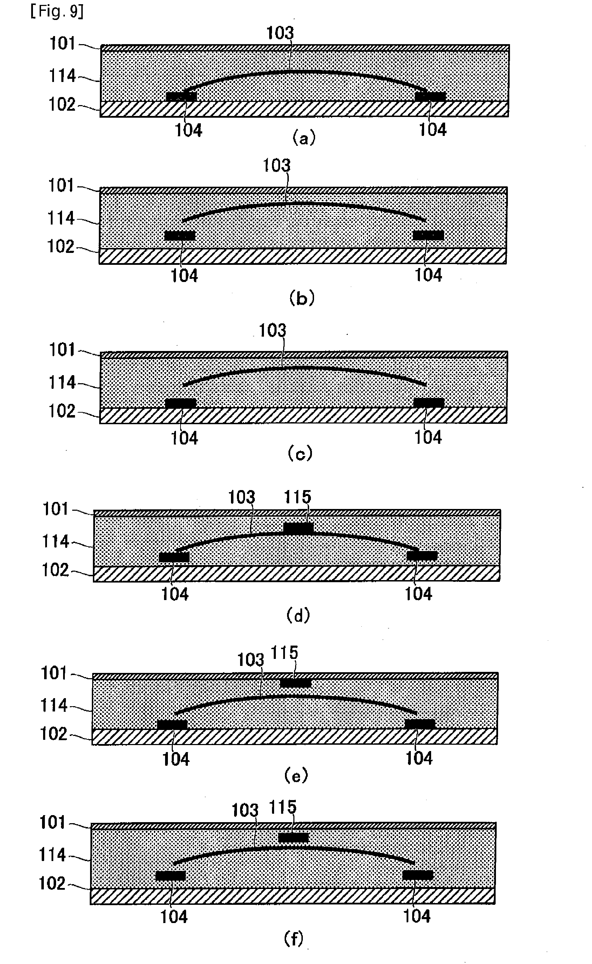

Next, an example of the laminated structure of the photovoltaic module when four corners of the photoelectric conversion element 103 of the photovoltaic module are warped to the lower surface and the central portion thereof protrudes toward the upper surface, which is the light incident surface, will be described with reference to Figs. 8(a) to 8(f) and Figs. 9(a) to 9(f). Figs. 8(a) to 8(f) are diagrams schematically illustrating the laminated structure of the photovoltaic module and Figs. 9(a) to 9(f) are cross-sectional views illustrating the laminated structure of the photovoltaic module shown in Figs. 8(a) to 8(f) after the laminate process. The laminated structure shown in Figs. 8(a) to 8(f) corresponds to the cross-sectional views of Figs. 9(a) to 9(f).

Figs. 8(a) to 8(c) show an example in which the insulating sheets 104 are provided only on the lower surface opposite to the light incident surface of the photovoltaic module. In the example shown in Fig. 8(a), the insulating sheets 104 are provided only at both ends of the lower surface of the photoelectric conversion element 103. In the example shown in Fig. 8(b), the insulating sheets 104 are provided at both ends of the lower surface of the photoelectric conversion element 103, an adhesive member 116 is provided between the insulating sheet 104 and the photoelectric conversion element 103, and the sealing member 106 is provided between the insulating sheets 104 and the reinforcing member 102. In the example shown in Fig. 8(c), the insulating sheets 104 are provided at both ends of the lower surface of the photoelectric conversion element 103, the sealing member 106 is provided between the insulating sheet 104 and the photoelectric conversion element 103, and the adhesive member 116 is provided between the insulating sheet 104 and the reinforcing member 102. When the members are laminated in this way, it is possible to arbitrarily adjust the laminated structure between the photoelectric conversion element 103 and the reinforcing member 102, as shown in Figs. 9(a) to 9(c).

Figs. 8(d) to 8(f) show an example in which the insulating sheets 104 are provided on the lower surface of the photoelectric conversion element 103 and the insulating sheet 115 is provided on the upper surface of the light incident surface. In the example shown in Fig. 8(d), the insulating sheet 115 is provided at the center of the upper surface of the photoelectric conversion element 103 and the insulating sheets 104 are provided at both ends of the lower surface of the photoelectric conversion element 103. In the example shown in Fig. 8(e), the insulating sheet 115 is provided at the center of the upper surface of the photoelectric conversion element 103 and the sealing member 105 is provided between the insulating sheet 115 and the photoelectric conversion element 103. The insulating sheets 104 are provided at both ends of the lower surface of the photoelectric conversion element 103 and the sealing member 106 is provided between the insulating sheets 104 and the photoelectric conversion element 103. In the example shown in Fig. 8(f), the insulating sheet 115 is provided at the center of the upper surface of the photoelectric conversion element 103, the sealing member 105 is provided between the insulating sheet 115 and the protective member 101, and the adhesive member 116 is provided between the insulating sheet 115 and the photoelectric conversion element 103. The insulating sheets 104 are provided at both ends of the lower surface of the photoelectric conversion element 103 and the adhesive member 116 is provided between the insulating sheet 104 and the photoelectric conversion element 103. The sealing member 106 is provided between the insulating sheets 104 and the reinforcing member 102. When the members are laminated in this way, it is possible to arbitrarily adjust the laminated structure between the photoelectric conversion element 103, and the protective member 101 and the reinforcing member 102, as shown in Figs. 9(d) to 9(f).

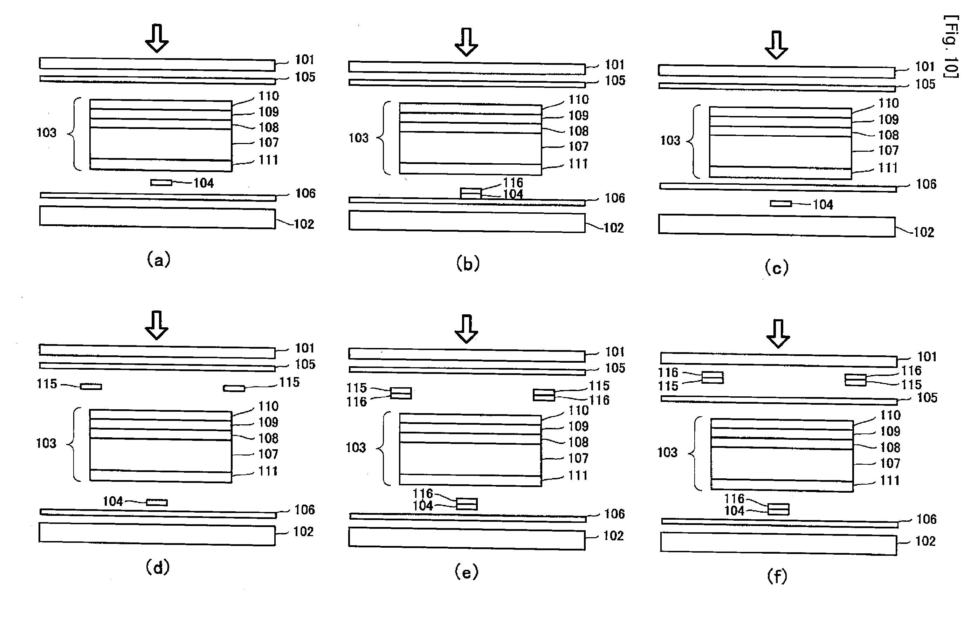

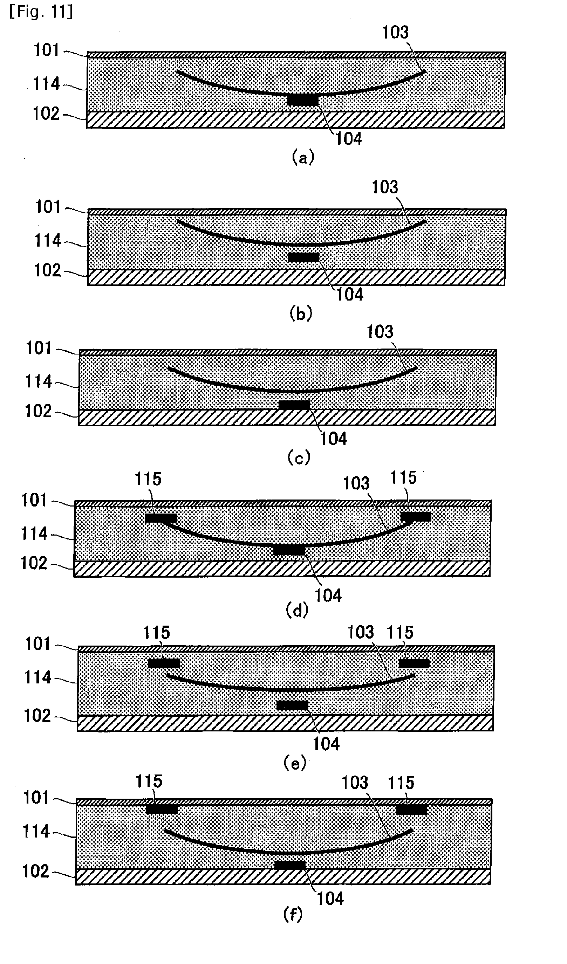

Next, an example of the laminated structure of the photovoltaic module when four corners of the photoelectric conversion element 103 of the photovoltaic module are warped to the upper surface and the central portion thereof protrudes toward the lower surface will be described with reference to Figs. 10(a) to 10(f) and Figs. 11(a) to 11(f). However, Figs. 10(a) to 10(f) are diagrams schematically illustrating the laminated structure of the photovoltaic module and Figs. 11(a) to 11(f) are diagrams schematically illustrating the laminated structure of the photovoltaic module shown in Figs. 10(a) to 10(f) after the laminate process. The laminated structure shown in Figs. 10(a) to 10(f) corresponds to the cross-sectional views of Figs. 11(a) to 11(f).

Figs. 10(a) to 10(c) show an example in which the insulating sheet 104 is provided only on the lower surface opposite to the light incident surface of the photovoltaic module. In the example shown in Fig. 10(a), the insulating sheet 104 is provided at the center of the lower surface of the photoelectric conversion element 103 and the sealing member 106 is provided between the insulating sheet 104 and the reinforcing member 102. In the example shown in Fig. 10(b), the insulating sheet 104 is provided at the center of the lower surface of the photoelectric conversion element 103, the sealing member 106 is provided between the insulating sheet 104 and the reinforcing member 102, and the adhesive member 116 is provided between the insulating sheet 104 and the photoelectric conversion element 103. In the example shown in Fig. 10(c), the insulating sheet 104 is provided at the center of the lower surface of the photoelectric conversion element 103 and the sealing member 106 is provided between the insulating sheet 104 and the photoelectric conversion element 103. When the members are laminated in this way, it is possible to arbitrarily adjust the laminated structure between the photoelectric conversion element 103 and the reinforcing member 102, as shown in Figs. 11(a) to 11(c).

Figs. 10(d) to 10(f) show an example in which the insulating sheet 104 is provided on the lower surface of the photoelectric conversion element 103 and the insulating sheets 115 are provided on the upper surface which is the light incident surface. In the example shown in Fig. 10(d), the insulating sheets 115 are provided at both ends of the upper surface of the photoelectric conversion element 103 and the sealing member 105 is provided between the insulating sheets 115 and the protective member 101. In the example shown in Fig. 10(e), the insulating sheets 115 are provided at both ends of the upper surface of the photoelectric conversion element 103, the sealing member 105 is provided between the insulating sheets 115 and the protective member 101, and the adhesive member 116 is provided between the insulating sheet 115 and the photoelectric conversion element 103. In the example shown in Fig. 10(f), the insulating sheets 115 are provided at both ends of the upper surface of the photoelectric conversion element 103, the sealing member 105 is provided between the insulating sheets 115 and the photoelectric conversion element 103, and the adhesive member 116 is provided between the insulating sheet 115 and the protective member 101. When the members are laminated in this way, it is possible to arbitrarily adjust the laminated structure between the photoelectric conversion element 103, and the protective member 101 and the reinforcing member 102, as shown in Figs. 11(d) to 11(f).

However, in the photovoltaic module according to this embodiment, the arrangement positions of the insulating sheets 104 and 115 are not particularly limited in the range in which the insulation resistance of the photoelectric conversion element 103 can be prevented from being reduced, under the conditions of use of the photovoltaic module. The insulating sheet 115 provided on the upper surface, which is the sunlight incident surface, of the photoelectric conversion element 103 is made of a material capable of transmitting light with a wavelength required to generate power.

The material forming the substrate 107 is not particularly limited. For example, the substrate 107 may be various kinds of members, such as a stainless substrate and a resin film made of, for example, PET, PEN, polyamide, polyamideimide, polyimide, polycarbonate, PBT, PPS, liquid crystal polymer, or PEI. Among the materials, it is preferable that the substrate 107 be made of polyimide with high insulation and heat resistance.

The electrode 108 may be made of a general electrode material and the material forming the electrode 108 is not particularly limited. The material forming the transparent electrode 110 is not particularly limited. In this embodiment, the electrode 108 is made of Ag and the transparent electrode 110 is made of ITO.

The photoelectric conversion layer 109 may be made of any known material used in the photovoltaic module and the material forming the photoelectric conversion layer 109 is not particularly limited. For example, the photoelectric conversion layer 109 may be made of amorphous silicon carbide (a-SiC), microcrystalline silicon (µc-Si), µc-SiGe, µc-SiC, µc-Ge amorphous silicon (a-Si), and amorphous silicon germanium (a-SiGe). In this embodiment, among them, µc-Ge amorphous silicon (a-Si) and amorphous silicon germanium (a-SiGe) are used.

It is preferable that the sealing members 105 and 106 be made of a material that is stable against heat or water in terms of airtightly sealing the photoelectric conversion element 103. Since the sealing member 105 is provided on the light incident side of the photoelectric conversion element 103, it is preferable that the sealing member 105 be stable against light and be transparent. In addition, it is preferable that the sealing member 105 be made of a material that can be laminated in a short time, has high adhesion to the protective member 101 and the reinforcing member 102, and can follow the shape of the photovoltaic device. Further, the sealing member 105 may be made of a material capable of absorbing damage. In this case, for example, the photovoltaic module can be formed so as to be used even in an environment in which external force is applied.

The sealing members 105 and 106 may be made of various kinds of resin materials that are likely to be softened and deformed by heating. The resin that is likely to be softened and deformed by heating may be a thermoplastic resin, a thermally crosslinkable resin, or a thermosetting resin. For example, ethylene-vinyl acetate copolymer (EVA), polyvinyl butyral, silicon resin, ethylene-acrylate copolymer resin, ethylene-methacrylic acid resin, acrylic resin, polyethylene, or polypropylene may be used. The upper sealing member 105 and the lower sealing member 106 may be made of different materials. Each of the sealing members 105 and 106 is not a single resin layer, but may be a plurality of resin layers. When each of the sealing members 105 and 106 is a plurality of resin layers, it is possible to form a photovoltaic module that can be used even in an environment in which external force is applied.

The protective member 101 may be made of any material capable of transmitting light, such as glass or a transparent resin. For example, it is preferable to use a film made of polyethylene tetrafluoro-ethylene (ETFE), PTFE, FEP, PFA, PVDF, or PVF or a silicon resin with optical transparency, weather resistance, and light weight. In this embodiment, FTFE is used.

The reinforcing member 102 may be made of the same material as that forming the protective member 101. For example, an aluminum plate, a steel plate, or a coated still plate may be used in terms of the strength or cost of the photovoltaic module. In this embodiment, a steel plate coated with a polyester resin is used.

The insulating sheets 104 and 115 may be made of any material with rigidity and insulation higher than those of the sealing members 105 and 106 under the installed conditions for the use of the photovoltaic module and the manufacturing conditions of the photovoltaic module. The insulating sheets 104 and 115 may be made of various kinds of materials, such as a glass nonwoven and a fluorine-based film material. When the glass nonwoven is used, the members are laminated in the above-mentioned way. When the fluorine-based film material is used, slippage occurs between the film material and the sealing member or between the photoelectric conversion element 103 and the film material during lamination. Therefore, the insulating sheets are formed such that the slippage of the film material can be prevented.

In this embodiment, the installed conditions for use mean the conditions that the photovoltaic device is installed on, for example, the roof of the house and is actually used, and are in the temperature range from room temperature to about 80°C. When the photovoltaic device is used in the temperature range, the sealing members 105 and 106 are softened and the photoelectric conversion element 103 is moved little by little by the residual stress of the substrate 107. The manufacturing conditions mean the conditions of a manufacturing environment after the sealing members 105 and 106 are provided in the photovoltaic device manufacturing process. In particular, in the photovoltaic device manufacturing process, the temperature when the sealing members 105 and 106 are arranged and laminated is about 150°C and the sealing members 105 and 106 are softened. Under the installed conditions for the use of the photovoltaic module and the manufacturing conditions of the photovoltaic module, the insulating sheets 104 and 115 are made of a material with rigidity and an insulation property more than those of the sealing members 105 and 10. Therefore, it is possible to prevent a reduction in insulation resistance.

In the photovoltaic module according to this embodiment, the photoelectric conversion layer 109 is laminated on the upper surface of the substrate 107. However, the photoelectric conversion layer 109 may be laminated on the lower surface of the substrate 107. In this case, the connection electrode 111 is provided on the upper surface of the substrate 107 and it is possible to extract a current from the upper surface.

In the photovoltaic module according to this embodiment, the photovoltaic device may have various kinds of structures. For example, various kinds of photovoltaic devices, such as a photovoltaic device with a single structure, a photovoltaic device with a tandem structure, a photoelectric conversion element of a photovoltaic device with a three-layer tandem structure, a compound-based photovoltaic device, a dye-sensitized photovoltaic device, and an organic photovoltaic device, may be used.

Next, the invention will be described in detail with reference to examples, but the invention is not limited to the examples.

### (Example 1)

A substrate of a photoelectric conversion element was made of polyimide with a thickness of about 50 µm. An Ag electrode (thickness: 200 nm), two pin junctions (a-Si/a-SiGe tandem junctions, thickness: 800 nm) as a photoelectric conversion layer, an ITO film (thickness: 70 nm) as a transparent electrode were formed on the upper surface of the substrate. An Ag electrode (300 nm) was formed as a connection electrode on the lower surface of the substrate. In addition, a glass nonwoven with a thickness of 0.2 mm was used as an insulating sheet, and an EVA film having a thickness 0.3 mm and a width of 300 mm and an MFR (melt mass-flow rate) of 30 g/10 min was used as the upper and lower sealing members of the substrate. A fluorine-based film ETFE was used as a protective member. A steel plate coated with a polyester resin was used as a reinforcing member. The photoelectric conversion element had a width of 400 mm and a depth 200 of mm, the steel plate had a width of 450 mm and a depth of 300 mm, and the glass nonwoven had a depth of 220 mm, a width of 20 mm, and a thickness of 0.3 mm. The glass nonwoven was arranged at a position that was 10 mm away from the end of the EVA film in the longitudinal direction on the lower surface of the substrate.

### (Laminate conditions)

The members laminated in this way were heated and the resin was melted by a vacuum laminate process such that the members were adhered. The vacuum laminate process was performed by the following profile. In the photovoltaic module according to this embodiment, warping did not occur in the photoelectric conversion element during the laminate process. The laminate conditions are shown in Table 1. When the members were laminated under these conditions, the insulating glass nonwoven was moved a maximum of 3 mm.

**[Table 1]**

| Process | Temperature (°C) | Pressing pressure (atm) | Time (minute) |
|---|---|---|---|
| ① Evacuation | 80 | 0 | 5 |
| ② Pressing | 120 | 1 | 10 |
| ③ Curing | 150 | 1 | 20 |

### (Evaluation of insulation resistance of photovoltaic module)

The electrodes at both ends of the photoelectric conversion element were connected to each other by a cable, and a voltage of 1000 V was applied between the connection portion and the steel plate. Then, the photovoltaic module was left in this state for 30 seconds until it become stable and the insulation resistance of the photovoltaic module was evaluated. Then, the high temperature/humidity test was performed under the conditions of a temperature of 85°C and a humidity of 95% for 3000 hours and the insulation property was evaluated. The evaluation result is shown in Table 1. The insulation property was good both before and after the high temperature/humidity test.

### (Example 2)

A photoelectric conversion element, a sealing member, and a protective member were formed by the same method as that in Example 1. An insulating sheet provided between the photoelectric conversion element and the protective member was made of ETFE with a thickness of 25 µm. The insulating sheet was arranged between the photoelectric conversion element and the sealing member such that the center of the insulating sheet in the lateral direction (width direction) was aligned with both ends of a light incident surface of the photoelectric conversion element in the longitudinal direction (width direction). In addition, a sealing member that was made of EVA with a thickness of 0.3 mm was provided between the insulating sheet and the photoelectric conversion element. The laminate process was performed under the same conditions as those in Example 1.

Insulation resistance was evaluated by the same method as that in Example 1. The evaluation result is shown in Table 1. Similar to Example 1, a good insulation property was obtained before and after the high temperature/humidity test.

### (Example 3)

A photoelectric conversion element, a sealing member, and a protective member were formed by the same method as that in Example 1. An insulating sheet provided between the photoelectric conversion element and the protective member was made of ETFE with a thickness of 25 µm. The insulating sheet was arranged between an EVA film formed on a surface opposite to a light incident surface of the photoelectric conversion element and a steel plate such that the center of the insulating sheet in the lateral direction (width direction) was aligned with both ends of the surface opposite to light incident surface of the photoelectric conversion element in the longitudinal direction (width direction). In addition, in order to fix the insulating sheet, a modified silicon adhesive was used between the insulating sheet and the steel plate. The laminate process was performed under the same conditions as those in Example 1.

Insulation resistance was evaluated by the same method as that in Example 1. The evaluation result is shown in Table 1. Similar to Examples 1 and 2, a good insulation property was obtained before and after the high temperature/humidity test.

### (Comparative example 1)

A photoelectric conversion element, a sealing member, and a protective member were formed by the same method as that in Example 1, but no insulating sheet was provided between the photoelectric conversion element and the sealing member. The laminate process was performed under the same conditions as those in Example 1.

Insulation resistance was evaluated by the same method as that in Example 1. The evaluation result is shown in Table 1. Before and after the high temperature/humidity test, the insulation resistance was low and did not reach a target value.

### (Comparative example 2)

A photoelectric conversion element, a sealing member, and a protective member were formed by the same method as that in Example 1, and an insulating sheet (having a width of 400 mm and a depth of 200 mm) made of a glass nonwoven was provided between the entire surfaces of the photoelectric conversion element and the sealing member. The laminate process was performed under the same conditions as those in Example 1.

Insulation resistance was evaluated by the same method as that in Example 1. The evaluation result is shown in Table 2. Before the high temperature/humidity test after manufacture, target insulation resistance was obtained, similar to Example 1, but the insulation resistance was reduced after the high temperature/humidity test.

**[Table 2]**

| | Example 1 | Example 2 | Example 3 | Comparative example 1 | Comparative example 2 |
|---|---|---|---|---|---|
| After manufacture (before high temperature/humidity test) | ○ | ○ | ○ | × | ○ |
| After high temperature/humidity test | ○ | ○ | ○ | × | × |

| | | | | | |
|---|---|---|---|---|---|
| Measurement result of insulation resistance (○: 1×10⁵ MΩ or more at 1000 V, ×: less than 1×10⁵ MΩ at 1000 V) | | | | | |

The invention is not limited to the above-described embodiments, but various modifications and changes of the invention can be made. In addition, the numerical values, dimensions, and materials according to the above-described embodiments are not particularly limited. For example, the thickness of the EVA film in Examples 1 to 3 is not limited to 0.3 mm, but may be in the range of about 0.1 mm to 2 mm. Various modifications and changes of the invention can be made without departing from the scope and spirit of the invention.

### Industrial Applicability

The invention can be applied to, for example, an outdoor photovoltaic module or a thin-film photovoltaic device.

Priority is claimed on Japanese Patent Application No. 2008-327954, filed December 24, 2008, the content of which is incorporated herein by reference.

## Claims

1. A photovoltaic module comprising:
a photoelectric conversion layer including a flexible substrate and a photoelectric conversion element layer that is formed on the flexible substrate;
protective members that are provided on both surfaces of the photoelectric conversion element and are adhered to the photoelectric conversion element with sealing members interposed therebetween; and
a sheet that is provided between the photoelectric conversion element and at least one of the protective members and has rigidity and insulation higher than those of the sealing member under manufacturing conditions of the photovoltaic module and installed conditions for use of the photovoltaic module.

2. The photovoltaic module according to claim 1,
wherein the sheet is arranged on the side to which at least four corners of the photoelectric conversion element are warped at positions including the four corners.

3. The photovoltaic module according to claim 2,
wherein the sheet is arranged on the side to which the four corners of the photoelectric conversion element are warped at positions including each side of both ends of the photoelectric conversion element in the longitudinal direction.

4. The photovoltaic module according to claim 2 or 3,
wherein the sheet is arranged on the side to which the four corners of the photoelectric conversion element are warped at the positions including each side of both ends of the photoelectric conversion element in the longitudinal direction and is arranged between the protective member and the sealing member.

5. The photovoltaic module according to any one of claims 1 to 4,
wherein the sheet has optical transparency and is provided on a light incident surface of the photoelectric conversion element.

6. The photovoltaic module according to any one of claims 1 to 5,
wherein the sheet is provided on a protruding portion of the photoelectric conversion element when the photoelectric conversion element is warped.

## Amended claims

### Amended claims under Art. 19.1 PCT

1. (Amended) A photovoltaic module comprising:
a photoelectric conversion layer including a flexible substrate and a photoelectric conversion element layer that is formed on the flexible substrate;
protective members that are provided on both surfaces of the photoelectric conversion element and are adhered to the photoelectric conversion element with sealing members interposed therebetween; and
a sheet that is provided between the photoelectric conversion element and at least one of the protective members and has rigidity and insulation higher than those of the sealing member under manufacturing conditions of the photovoltaic module and installed conditions for use of the photovoltaic module, wherein
the sheet is arranged on the side to which at least four corners of the photoelectric conversion element are warped at positions including the four corners.

2. (Deleted)

3. (Amended) The photovoltaic module according to claim 1,
wherein the sheet is arranged on the side to which the four corners of the photoelectric conversion element are warped at positions including each side of both ends of the photoelectric conversion element in the longitudinal direction.

4. (Amended) The photovoltaic module according to claim 1 or 3,
wherein the sheet is arranged on the side to which the four corners of the photoelectric conversion element are warped at the positions including each side of both ends of the photoelectric conversion element in the longitudinal direction and is arranged between the protective member and the sealing member.

5. (Amended) The photovoltaic module according to any one of claims 1 to 3,
wherein the sheet has optical transparency and is provided on a light incident surface of the photoelectric conversion element.

6. (Amended) The photovoltaic module according to any one of claims 1 to 3,
wherein the sheet is provided on a protruding portion of the photoelectric conversion element when the photoelectric conversion element is warped.
